# EUROPÄISCHE PATENTSCHRIFT

(11) **EP 1 676 321 B1**
(45) Veröffentlichungstag und Bekanntmachung des Hinweises auf die Patenterteilung: **01.12.2010**
(21) Anmeldenummer: 04817258.9
(22) Anmeldetag: 15.10.2004
(51) Int. Cl.: H01L 27/08

(54) **KONDENSATORANORDNUNG IN EINEM HALBLEITERBAUELEMENT UND VERFAHREN ZUR ANSTEUERUNG EINES KONDENSATORS**
CAPACITOR ARRANGEMENT IN A SEMICONDUCTOR ELEMENT AND METHOD OF CONTROLLING A CAPACITOR
SYSTEME DE CONDENSATEUR DANS UN ELEMENT A SEMI-CONDUCTEURS ET METHODE DE COMMANDE D'UN CONDENSATEUR

(30) Priorität: 22.10.2003 DE 10349557
(43) Veröffentlichungstag der Anmeldung: 05.07.2006
(73) Patentinhaber: Infineon Technologies AG, 85579 Neubiberg (DE)
(72) Erfinder: ALLERS, Karl-Heinz, 85540 Haar (DE); SCHWAB, Reiner, 83734 Hausham (DE)
(74) Vertreter: Lippert, Stachow & Partner
(86) Internationale Anmeldenummer: PCT/DE2004/002301
(87) Internationale Veröffentlichungsnummer: WO 2005/041300

(56) Entgegenhaltungen:
- US-A- 4 897 774
- US-A- 5 270 913
- US-A- 5 274 586
- US-A1- 2001 015 449

## Beschreibung

Die Erfindung betrifft eine Kondensatoranordnung in einem Halbleiterbauelement mit einer ersten Kondensatorelektrode, einer zweiten Kondensatorelektrode und einem, von den Kondensatorelektroden eingeschlossenen Dielektrikum, wobei an den Kondensatorelektroden eine Kondensatorspannung anlegbar ist.

Die Erfindung betrifft auch ein Verfahren zur Ansteuerung eines Kondensators in einem Halbleiterbauelement, der von seiner äußeren Beschaltung unipolar betrieben wird, wobei an den Kondensatorelektroden eine Kondensatorspannung angelegt wird.

Kondensatoren stellen grundelementare Bestandteile der Halbleitertechnik dar und können innerhalb eines Halbleiterbauelements verschiedene Funktionen übernehmen. Dabei kommen im wesentlichen zwei verschiedene Betriebsarten in Frage, der unipolare Betrieb und der bipolare Betrieb. Dabei wird unter unipolarem Betrieb ein Beaufschlagen des Kondensators mit eine Spannung gleicher Polarität, jedoch nicht notwendiger Weise gleicher Amplitude verstanden. Ein Beaufschlagen mit einer Gleichspannung, die eine gleiche Polarität und gleiche Amplitude aufweist, ist damit eine Sonderform des unipolaren Betriebes. Unter bipolarem Betrieb wird das Beaufschlagen.mit einer Spannung wechselnder Polarität verstanden.

Je nach Betriebsart werden unipolar betriebene Kondensatoren beispielsweise zum Schutz vor Stromspitzen innerhalb des Halbleiterbauelements und bipolare Kondensatoren zum Filtern von Signalen eingesetzt.

Es ist bekannt, dass integrierte Kondensatoren eine begrenzte Lebensdauer aufweisen, welche neben diversen Betriebsparametern wie Temperatur und angelegter Spannung direkt mit der Dicke des verwendeten Dielektrikums zusammenhängt.

Experimentell wurde nachgewiesen, dass bestimmte im Halbleiterbereich verwendete Dielektrika im bipolaren Betrieb eine höhere Lebensdauer aufweisen, als im unipolaren Betrieb. Somit müssen für unipolar betriebene Kondensatoren entweder eine höhere Dicke des Dielektrikums, oder aber eine geringere Lebensdauer in Kauf genommen werden.

In der US 5,274,586 wird eine Kondensatoranordnung beschrieben, die in einen MOS-Halbleiterspeicher eingesetzt ist. Diese Lösung nimmt sich einer Verbesserung der Lebensdauer der Kondensatoranordnung dadurch an, dass die Spannung der einen (der oberen) Kondensatorelektrode größer Null eingestellt wird und kleiner als der arithmetische Durchschnitt der maximalen Logikspannung V_{H} und der minimalen Logikspannung V_{L}, die am Speicherknoten anliegt.

In der US 4,897,774 wird eine Schaltungsanordnung zur Bereitstellung einer bezüglich einem Massepotential bipolaren Betriebsspannung beschrieben. Darin wird durch ein jeweiliges Zu- und Umschalten von Kondensatoren zunächst eine Verdopplung der von einer Spannungsquelle bereitgestellten Spannung vorgenommen, die von einem Vorratskondensator gespeichert wird. Diese wird dann von einem Transferkondensator übernommen. Mittels einer Umschaltung diese Transferkondensators wird der invertierte Teil der bipolaren Betriebsspannung bereit gestellt, während der nicht invertierte Teil dem Vorratskondensator entnommen wird. Eine Umschaltung der Polaritäten an den Kondensatorelektroden erfolgt an keinem der Kondensatoren, insbesondere nicht am Transferkondensator.

Der Erfindung liegt deshalb die Aufgabe zugrunde eine Schaltungsanordnung und ein verfahren zur Ansteuerung eines Kondensators zu schaffen, welche die Lebensdauer einer Kondensatoranordnung verbesserh.

Die der Erfindung zugrunde liegende Aufgabe wird durch eine Kondensatorschaltungsanordnung dadurch gelöst, dass eine Umschaltanordnung mit einem ersten und einem zweiten Eingang und einem ersten und zweiten Ausgang angeordnet ist. Dabei stellt für eine äußere Beschaltung des Kondensators der erste Eingang den Anschluss für die erste Kondensatorelektrode und der zweite Eingang den Anschluss für die zweite Kondensatorelektrode dar. Die Umschaltanordnung hat zwei Ausgänge, welche derart ausgeführt sind, dass der erste Ausgang mit der ersten Kondensatorelektrode sowie der zweite Ausgang mit der zweiten Kondensatorelektrode verbunden ist. In der Umschaltanordnung ist in einer ersten Schalterstellung der erste Eingang mit dem ersten Ausgang und der zweite Eingang mit dem zweiten Ausgang und in einer zweiten Schalterstellung der erste Eingang mit dem zweiten Ausgang und der zweite Eingang mit dem ersten Ausgang verbunden. Diese Kondensatorschaltungsanordnung ermöglicht das Wechseln der Polarität an den Kondensatorelektroden.

In einer günstigen Ausgestaltung der Erfindung weist die Umschaltanordnung einen Steuereingang, welcher mit einem Steuersignalgeber verbunden ist auf, der somit einen von außen elektronisch schaltbaren Umschaltvorgang ermöglicht.

Des weiteren wird die der Erfindung zugrunde liegende Aufgabe durch ein Verfahren zur Ansteuerung gelöst, welches die Kondensatorschaltungsanordnung so ansteuert, dass die Kondensatorspannung während der unipolaren äußeren Beschaltung und während eines Gesamtzeitraumes in der Polarität wechselnd angelegt wird, derart, dass sie in einer ersten Polarität während erster Zeiträume und in einer zu der ersten Polarität entgegengesetzten zweiten Polarität während zweiter Zeiträume angelegt wird.

Der dabei erzielte Effekt ist, das es möglich wird, einen bisher rein unipolar betriebenen Kondensator durch einen Polaritätswechsel nun bipolar zu betreiben und damit die Lebensdauer desselben signifikant zu verlängern.

Um eine optimale Ausnutzung des Effektes zur Lebensdauerverlängerung des Kondensators zu erreichen, sollten sich die Stress-Niveaus beider Polaritäten kompensieren.

Für Anwendungen, in denen der Kondensator mit Gleichspannung betrieben wird, ist es daher notwendig, das die kumulierte Zeit, in der der Kondensator in der ersten Polarität betrieben wird, annähernd gleich ist zur kumulierten Zeit, in der der Kondensator in der zweiten Polarität betrieben wird. Diese Art der Anwendung wird für den Einsatz der Erfindung bevorzugt.

Für Anwendungen, in denen der Kondensator mit einer zeitlich veränderlichen Spannung betrieben wird, muss sich das Zeitintegral aus dem Produkt aus Zeit und einer geeigneten Funktion der Spannung für beide Polaritäten annähernd ausgleichen.

Für eine erfindungsgemäße Durchführung des Verfahrens kann es sich bei der ursprünglich angelegten Kondensatorspannung sowohl um eine konstante Gleichspannung als auch um eine pulsierende Gleichspannung handeln. Somit ist das Verfahren auf alle unipolar betriebenen Kondensatoren anwendbar.

Um den gewünschten Effekt zu erzielen, können die ersten und zweiten Zeiträume Sekunden bis Wochen betragen.

In einer weiteren Variante des erfindungsgemäßen Verfahrens erfolgt die Ansteuerung der Umschaltanordnung über ein Steuersignal. Dies hat den Vorteil einer möglichen Automatisierung der Polaritätswechsel der Kondensatorspannung. Es besteht die Möglichkeit als Steuersignal das Anlegen der Betriebsspannung an das Halbleiterbauelement zu nutzen. Des weiteren besteht die Möglichkeit als Steuersignal einen intern generierten Takt zu nutzen. Der Vorteil bei einer dieser beiden Ausführung des Verfahrens besteht darin, eine komplett automatische Umschaltung der Polarität der Kondensatorspannung zu erreichen.

Mit Hilfe der durch die Erfindung erreichten, erheblichen Verlängerung der Lebensdauer des Kondensators ist es möglich, die Zuverlässigkeit und Lebensdauer des Kondensators, und damit des gesamten Halbleiterbauelements zu erhöhen. Zum anderen ist es möglich die für eine Soll-Lebensdauer erforderliche Dicke des Dielektrikums zu senken und damit den Platzbedarf des Kondensators im Halbleiterbauelement zu reduzieren.

Die Erfindung soll nachfolgend anhand zweier Ausführungsbeispiele näher erläutert werden. In den zugehörigen Zeichnungen zeigt
- Fig. 1: eine erfindungsgemäße Verteilung der Polarität der Kondensatorspannung,
- Fig. 2: eine erfindungsgemäße Verteilung der Polarität der Kondensatorspannung als pulsierender Gleichspannung,
- Fig. 3: eine erfindungsgemäße Kondensatorschaltungs- anordnung.

Wie in den Zeichnungen dargestellt, ändert sich die Polarität am Kondensator 1 durch ein je nach Anwendungsfall zu wählendes regelmäßiges Ereignis N. Das Ereignis N wird gebildet durch das Anlegen der Betriebsspannung an das Halbleiterbauelement oder durch einen intern generierten Takt.

In diesem Ausführungsbeispiel besteht der Kondensator aus zwei TiN Elektroden und einem von den Elektroden eingeschlossenem SiN Dielektrikum.

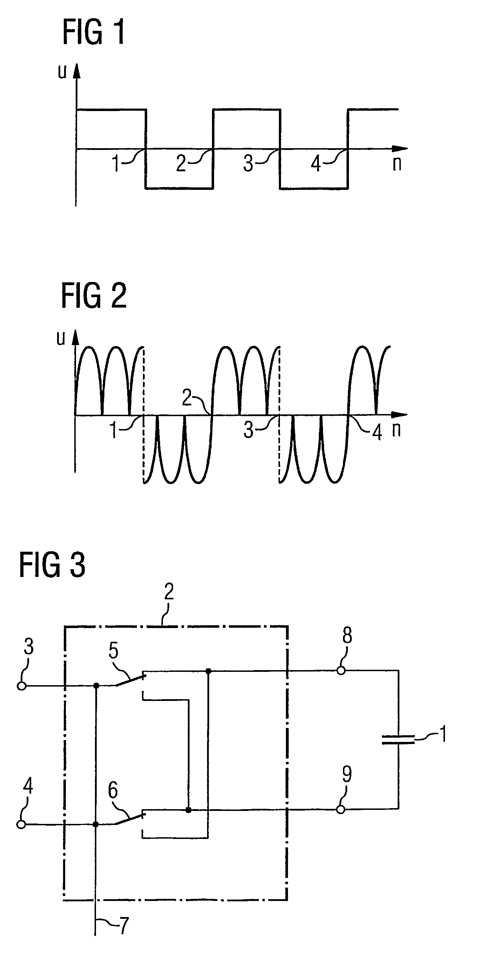

In Fig.3 ist eine mit herkömmlichen Bauteilen stilisierte Umschaltanordnung 2 zur Realisierung der Umkehrung der Polarität am Kondensator 1 dargestellt. Die Kondensatorschaltungsanordnung besteht aus einem ersten Eingang 3 und einem zweiten Eingang 4 sowie einer Umschaltanordnung 2 welche einen ersten Schalter 5 und eine zweiten Schalter 6 enthält, beide Schalter sind über eine Steuerleitung 7 elektronisch steuerbar. Die Umschaltanordnung 2 hat einen ersten Ausgang 8 und einen zweiten Ausgang 9 welche gleichermaßen die Eingänge des Kondensators 1 darstellen.

Wird ein, durch ein Ereignis N ausgelöstes, Steuersignal an der Steuerleitung 7 angelegt, so werden die Schalter 3 und 4 betätigt und die Verbindungen zwischen erstem Eingang 3 und erstem Ausgang 8 und zweitem Eingang 4 und zweitem Ausgang 9 wechselseitig vertauscht. Dadurch ergeben sich, je nach angelegtem Signal, in Abhängigkeit vom Ereignis N, Kondensatorspannungsverläufe wie in Fig.1 oder Fig.2 dargestellt.

### Bezugszeichenliste

- 1: Kondensator
- 2: Umschaltanordnung
- 3: Erster Eingang
- 4: Zweiter Eingang
- 5: Erster Schalter
- 6: Zweiter Schalter
- 7: Steuerleitung
- 8: Erster Ausgang
- 9: Zweiter Ausgang
- N: Ereignis

## Patentansprüche

1. Kondensatoranordnung in einem Halbleiterbauelement mit einer ersten Kondensatorelektrode, einer zweiten Kondensatorelektrode und einem, von den Kondensatorelektroden eingeschlossenen Dielektrikum, wobei an den Kondensatorelektroden eine Kondensatorspannung anlegbar ist,
**dadurch gekennzeichnet, dass** eine Umschaltanordnung mit einem ersten und einem zweiten Eingang und einem ersten und zweiten Ausgang angeordnet ist, wobei für eine äußere Beschaltung des Kondensators der erste Eingang den Anschluss für die erste Kondensatorelektrode und der zweite Eingang den Anschluss für die zweite Kondensatorelektrode darstellt und der erste Ausgang mit der ersten Kondensatorelektrode sowie der zweite Ausgang mit der zweiten Kondensatorelektrode verbunden ist und wobei in der Umschaltanordnung in einer ersten Schalterstellung der erste Eingang mit dem ersten Ausgang und der zweite Eingang mit dem zweiten Ausgang und in einer zweiten Schalterstellung der erste Eingang mit dem zweiten Ausgang und der zweite Eingang mit dem ersten Ausgang verbunden ist.

2. Umschaltanordnung nach Anspruch 1, **dadurch gekennzeichnet, dass** die Umschaltanordnung einen, die Schalterstellung steuernden, Steuereingang aufweist.

3. Umschaltanordnung nach Anspruch 2, **dadurch gekennzeichnet, dass** der Steuereingang mit einem Steuersignalgeber verbunden ist.

4. Verfahren zur Ansteuerung eines Kondensators in einem Halbleiterbauelement, der von seiner äußeren Beschaltung unipolar betrieben wird, wobei an den Kondensatorelektroden eine Kondensatorspannung angelegt wird, **dadurch gekennzeichnet, dass** während der unipolaren äußeren Beschaltung die Kondensatorspannung während eines Gesamtzeitraumes in der Polarität wechselnd angelegt wird, derart, dass sie in einer ersten Polarität während erster Zeiträume und in einer zu der ersten Polarität entgegengesetzten zweiten Polarität während zweiter Zeiträume angelegt wird.

5. Verfahren nach Anspruch 4, **dadurch gekennzeichnet, dass** die Summe der Zeiten der ersten Zeiträume und die Summe der Zeiten der zweiten Zeiträume im Gesamtzeitraum im Betrag annähernd gleich sind.

6. Verfahren nach Anspruch 4, **dadurch gekennzeichnet, dass** die Zeitintegrale der Spannungsfunktion der ersten Zeiträume und die Zeitintegrale der Spannungsfunktion der zweiten Zeiträume im Betrag annähernd gleich sind.

7. Verfahren nach Anspruch 4 oder 6, **dadurch gekennzeichnet, dass** für die Kondensatorspannung eine pulsierende Gleichspannung eingesetzt wird.

8. Verfahren nach einem der Ansprüche 4 bis 7, **dadurch gekennzeichnet, dass** die ersten und zweiten Zeiträume Sekunden bis Wochen betragen können.

9. Verfahren nach einem der Ansprüche 4 bis 8, **dadurch gekennzeichnet, dass** der Polaritätswechsel durch ein Steuersignal gesteuert wird.

10. Verfahren nach Anspruch 9, **dadurch gekennzeichnet, dass** das Steuersignal zum Zeitpunkt des Anlegens einer Betriebsspannung an ein Halbleiterbauelement erzeugt wird.

11. Verfahren nach Anspruch 9, **dadurch gekennzeichnet, dass** das Steuersignal aus einem internen Takt in dem Halbleiterbauelement intern erzeugt wird.

## Claims

1. Capacitor arrangement in a semiconductor component having a first capacitor electrode, a second capacitor electrode and a dielectric that is surrounded by the capacitor electrodes, it being possible to apply a capacitor voltage to the capacitor electrodes, **characterized in that** a changeover arrangement having a first input and a second input and a first output and a second output is provided, in which case, in order to externally connect the capacitor, the first input constitutes the terminal for the first capacitor electrode and the second input constitutes the terminal for the second capacitor electrode, and the first output is connected to the first capacitor electrode and the second output is connected to the second capacitor electrode, and in which case, in a first switch position in the changeover arrangement, the first input is connected to the first output and the second input is connected to the second output and, in a second switch position, the first input is connected to the second output and the second input is connected to the first output.

2. Changeover arrangement according to Claim 1, **characterized in that** the changeover arrangement has a control input that controls the switch position.

3. Changeover arrangement according to Claim 2, **characterized in that** the control input is connected to a control signal generator.

4. Method for driving a capacitor in a semiconductor component, which capacitor is operated in a unipolar manner from its external connection, a capacitor voltage being applied to the capacitor electrodes, **characterized in that**, during the unipolar external connection, the capacitor voltage is applied, with alternating polarity, during an overall period of time in such a manner that it is applied with a first polarity during first periods of time and with a second polarity that is opposite to the first polarity during second periods of time.

5. Method according to Claim 4, **characterized in that** the magnitude of the sum of the times of the first periods of time and the magnitude of the sum of the times of the second periods of time are approximately the same in the overall period of time.

6. Method according to Claim 4, **characterized in that** the magnitude of the time integrals of the voltage function of the first periods of time and the magnitude of the time integrals of the voltage function of the second periods of time are approximately the same.

7. Method according to Claim 4 or 6, **characterized in that** a pulsating DC voltage is used for the capacitor voltage.

8. Method according to one of Claims 4 to 7, **characterized in that** the first and second periods of time may be seconds to weeks.

9. Method according to one of Claims 4 to 8, **characterized in that** the change in polarity is controlled using a control signal.

10. Method according to Claim 9, **characterized in that** the control signal is generated when an operating voltage is applied to a semiconductor component.

11. Method according to Claim 9, **characterized in that** the control signal is internally generated from an internal clock in the semiconductor component.

## Revendications

1. Arrangement de condensateur dans un composant semiconducteur comprenant une première électrode de condensateur, une deuxième électrode de condensateur et un diélectrique enrobé par les électrodes de condensateur, une tension de condensateur pouvant être appliquée aux électrodes de condensateur,
**caractérisé en ce qu'**un arrangement d'inversion est disposé avec une première et une deuxième entrée et avec une première et une deuxième sortie, la première entrée représentant la borne pour la première électrode de condensateur et la deuxième entrée la borne pour la deuxième électrode de condensateur pour une connexion externe du condensateur et la première sortie étant reliée avec la première électrode de condensateur et la deuxième sortie avec la deuxième électrode de condensateur et, dans l'arrangement d'inversion, dans une première position de commutation, la première entrée étant reliée avec la première sortie et la deuxième entrée avec la deuxième sortie et, dans une deuxième position de commutation, la première entrée étant reliée avec la deuxième sortie et la deuxième entrée avec la première sortie.

2. Arrangement d'inversion selon la revendication 1, **caractérisé en ce que** l'arrangement d'inversion présente une entrée de commande qui commande la position de commutation.

3. Arrangement d'inversion selon la revendication 2, **caractérisé en ce** l'entrée de commande est reliée à un générateur de signal de commande.

4. Procédé de commande d'un condensateur dans un composant semiconducteur qui fonctionne de manière unipolaire de par sa connexion externe, une tension de condensateur étant appliquée aux électrodes de condensateur, **caractérisé en ce que** pendant la connexion externe unipolaire, la tension de condensateur est appliquée avec alternance de la polarité pendant une période totale, de sorte qu'elle est appliquée avec une première polarité pendant des premières périodes et avec une deuxième polarité opposée à la première polarité pendant des deuxièmes périodes.

5. Procédé selon la revendication 4, **caractérisé en ce que** la somme des temps des premières périodes et la somme des temps des deuxièmes périodes dans la période totale ont des valeurs approximativement égales.

6. Procédé selon la revendication 4, **caractérisé en ce que** l'intégrale de temps de la fonction de tension des premières périodes et l'intégrale de temps de la fonction de tension des deuxièmes périodes ont des valeurs approximativement égales.

7. Procédé selon la revendication 4 ou 6, **caractérisé en ce qu'**une tension continue impulsionnelle est utilisée pour la tension de condensateur.

8. Procédé selon l'une des revendications 4 à 7, **caractérisé en ce que** la première et la deuxième périodes peuvent durer de quelques secondes à plusieurs semaines.

9. Procédé selon l'une des revendications 4 à 8, **caractérisé en ce que** le changement de polarité est commandé par un signal de commande.

10. Procédé selon la revendication 9, **caractérisé en ce que** le signal de commande est généré au moment de l'application d'une tension de service à un composant semiconducteur.

11. Procédé selon la revendication 9, **caractérisé en ce que** le signal de commande est généré en interne à partir d'une horloge interne dans le composant semiconducteur.
